# EUROPEAN PATENT APPLICATION

(11) **EP 4 825 938 A1**
(43) Date of publication of application: **21.10.2026**
(21) Application number: 24903457.0
(22) Date of filing: 21.11.2024
(51) Int. Cl.: C09J 153/00, B60J 10/80, C09J 11/08, C09J 153/02, C09K 3/10, H01M 50/171, H01M 50/242, H10F 19/80

(54) **ADHESIVE COMPOSITION AND SHEET-LIKE GASKET, FLOOR MATERIAL, SEALING MATERIAL FOR AUTOMOBILE DOOR INNER SECTION, CUSHIONING MATERIAL FOR FUEL TANK, SEALING MATERIAL FOR ELECTRONIC COMPONENT, CUSHIONING MATERIAL FOR LITHIUM ION BATTERY, SEALING MATERIAL FOR USE BETWEEN SOLAR CELL PANEL AND SUPPORTING MEMBER OF MODULE FOR SOLAR CELL, SEALING MATERIAL FOR ELECTRONIC EQUIPMENT, SEALING MATERIAL FOR ELECTROLYTIC DEVICE, AND SEALING MATERIAL**

(30) Priority: 13.12.2023 JP 2023209879
(71) Applicant: NICHIAS CORPORATION, Tokyo 104-8555 (JP)
(72) Inventor: ASANUMA, Shuji, Tokyo 104-8555 (JP)
(74) Representative: Grünecker Patent- und Rechtsanwälte PartG mbB
(86) International application number: PCT/JP2024/041329
(87) International publication number: WO 2025/126798

(57) **Abstract**

Provided is an adhesive composition containing a copolymer (A) having (a) a polymer block of an α-methylstyrene monomer and (b) a (co)polymerization block of one or more kinds of aliphatic monoolefins and/or one or more kinds of aliphatic conjugated diolefins or a partially or fully hydrogenated block of the (co)polymerization block, one or more kinds of copolymers (B) having (c) a polymer block of a styrene monomer and (d) a (co)polymerization block of one or more kinds of aliphatic monoolefins and/or one or more kinds of aliphatic conjugated diolefins or a partially or fully hydrogenated block of the (co)polymerization block, and an adhesion imparting agent (C). The present invention can provide an adhesive composition for forming an adhesive layer to be provided on the surface of an elastic rubber material, which is the main material of a sealing material, the adhesive composition capable of forming the adhesive layer with excellent adhesion both at high temperatures (80°C or higher, for example, 100°C) and at normal temperatures of about 25°C.

## Description

### TECHNICAL FIELD

The present invention relates to an adhesive composition for use in forming an adhesive layer, and a sheet-shaped gasket, a flooring material, a sealing material for inside an automotive door, a cushioning material for a fuel tank, a sealing material for an electronic component, a cushioning material for a lithium-ion battery, a sealing material between a solar cell panel and a support member of a module for a solar cell, a sealing material for an electronic device, a sealing material for an electrolytic apparatus, and a sealing material containing the same.

### BACKGROUND ART

A fuel cell (FEFC) includes an ion exchange membrane (an electrolyte body), an oxygen electrode, a hydrogen electrode, a support current collector, and carbon separators having a rectifying groove that allows gas to flow on one side and a rectifying groove that allows cooling water to flow on the other side, in which the ion exchange membrane and the two electrodes that are integrated are put between the separators to form a single cell.

Then, many single cells are stacked side by side to form a stack, metal current collector plates are interposed at both ends of the stack to be external current extraction terminals, a clamping plate is placed via an insulating plate, and the whole is bolted together to form the fuel cell.

In such separators for a fuel cell, gaskets are used in order to prevent leakage of the cooling water. For example, Patent Literature 1 discloses a separator for use in a fuel cell in which electrodes are disposed on both sides of an ion exchange membrane, which are put between the separators to form a single cell, the separator structure for a fuel cell including a gasket or rubber ring integrated with the separator by adhesion.

In automotive electronic components, since the inside electronic component body is required to be isolated from the outside air, sealing materials with excellent sealability are required at the contact parts between external connection components and an enclosure and at the overlapping parts between the enclosures. In electronic devices used for purposes other than automobiles too, since the inside electronic component body is required to be isolated from the outside air, sealing materials with excellent sealability are required at the contact parts between external connection components and an enclosure and at the overlapping parts between the enclosures.

In solar cell modules, to keep out moisture from the outside, sealing materials with excellent sealability are required between a solar cell panel and its support member.

In stacked lithium-ion batteries, cushioning materials are provided between stacked cells to fix the cells while following the expansion or contraction of the cells.

In electrolytic apparatuses, sealing materials for an electrolytic cell are used.

### CITATION LIST

### PATENT LITERATURE

Patent Literature 1: Japanese Patent Publication 2000-156234-A

### SUMMARY OF INVENTION

### Technical Problem

In the above conventional technologies, sealability is enhanced by increasing the elastic modulus of a solid rubber material, which is the main material of the sealing material, or by increasing the compressive stress of a foam rubber material.

However, if the crosslink density of the solid rubber is increased too much in order to increase the elastic modulus of the solid rubber material or if the foaming rate is decreased too much in order to increase the compressive stress of the foam rubber material, high surface pressure will be generated at sealing parts, which will unfortunately damage other materials with low strength. On the other hand, if the elastic modulus of the solid rubber is decreased or if the foaming rate is increased too much in order to avoid high surface pressure from being generated at the sealing parts, sagging of the sealing material will unfortunately increase due to changes over time.

Given these circumstances, it is necessary to improve the sealability of the sealing material by methods other than increasing the elastic modulus of the solid rubber material, which is the main material of the sealing material, or increasing the recovery rate of the foam rubber material. One of the methods is to provide an adhesive layer using an adhesive composition on the surface of an elastic rubber material such as the solid rubber material, which is the main material of the sealing material, or the foam rubber material to increase the adhesion of the elastic rubber material to an object to be sealed, thereby enhancing the close adhesion between the elastic rubber material and the object to be sealed.

For the sealing material, a resin material, a metal material, a paper material, or a cork material may be used. In that case too, as with the elastic rubber material, to enhance the sealability of the sealing material, an adhesive layer is provided on the surface of the resin material, the metal material, the paper material, or the cork material to increase the adhesion of the resin material to the object to be sealed, thereby enhancing the close adhesion between the resin material, the metal material, the paper material, or the cork material and the object to be sealed.

Alternatively, only an adhesive layer composed of an adhesive composition may be used as the sealing material without a base material such as an elastic rubber material, a resin material, a metal material, a paper material, or a cork material.

Automotive electronic components, solar modules, automotive lithium-ion secondary batteries, and the like may locally or temporarily reach high temperatures (80°C or higher, for example, 100°C) during the summer. Electrolytic apparatuses may also be subject to high temperatures.

Given these circumstances, sealing materials with excellent sealability not only at normal temperatures of about 25°C but also at high temperatures (80°C or higher, for example, 100°C) are required, and thus the sealing material in which the adhesive layer is provided on the elastic rubber material, the resin material, the metal material, the paper material, or the cork material requires an adhesive layer with excellent adhesion not only at normal temperatures of about 25°C but also at high temperatures (80°C or higher, for example, 100°C).

In the sealing material formed only of the adhesive layer composed of the adhesive composition too, sealing materials with excellent sealability not only at normal temperatures of about 25°C but also at high temperatures (80°C or higher, for example, 100°C) are required, and thus the sealing material formed only of the adhesive layer composed of the adhesive composition requires an adhesive layer with excellent adhesion not only at normal temperatures of about 25°C but also at high temperatures (80°C or higher, for example, 100°C).

Thus, an object of the present invention is either (1) or (2) below:
(1) An object thereof is to provide an adhesive composition for forming an adhesive layer to be provided on the surface of an elastic rubber material, which is the main material of a sealing material, a resin material, a metal material, a paper material, or a cork material, the adhesive composition capable of forming the adhesive layer with excellent adhesion both at high temperatures (80°C or higher, for example, 100°C) and at normal temperatures of about 25°C.
(2) An object thereof is to provide an adhesive composition for forming an adhesive layer in a sealing material formed only of the adhesive layer composed of the adhesive composition, the adhesive composition capable of forming the adhesive layer with excellent adhesion both at high temperatures (80°C or higher, for example, 100°C) and at normal temperatures of about 25°C.

### Solution to Problem

The above objects are achieved by the following.

That is, the present invention (1) provides an adhesive composition containing:
a copolymer (A) having (a) a polymer block of an α-methylstyrene monomer and (b) a (co)polymerization block of one or more kinds of aliphatic monoolefins and/or one or more kinds of aliphatic conjugated diolefins or a partially or fully hydrogenated block of the (co)polymerization block;
one or more kinds of copolymers (B) having (c) a polymer block of styrene or a monomer having a styrene structure and (d) a (co)polymerization block of one or more kinds of aliphatic monoolefins and/or one or more kinds of aliphatic conjugated diolefins or a partially or fully hydrogenated block of the (co)polymerization block; and
an adhesion imparting agent (C).

The present invention (2) provides the adhesive composition according to (1), in which a ratio of a content of the copolymer (A) to a total content of the copolymer (A) and the copolymer (B) ((copolymer (A)/(copolymer (A) + copolymer (B))) × 100) is 5 to 95% by mass.

The present invention (3) provides the adhesive composition according to (1), in which a content of an α-methylstyrene unit of the copolymer (A) is 10 to 40% by mass on a monomer basis.

The present invention (4) provides the adhesive composition according to (1), in which a content of a styrene unit of the copolymer (B) is 5 to 25% by mass on a monomer basis.

The present invention (5) provides the adhesive composition according to (1), in which (b) is a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block.

The present invention (6) provides the adhesive composition according to (1), in which (d) is a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block.

The present invention (7) provides the adhesive composition according to (1), in which the copolymer (A) is a triblock copolymer composed of (a) a polymer block of an α-methylstyrene monomer-(b) a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block-(a) a polymer block of an α-methylstyrene monomer.

The present invention (8) provides the adhesive composition according to (1), in which the copolymer (B) is a triblock copolymer composed of (c) a polymer block of styrene or a monomer having a styrene structure-(d) a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block-(c) a polymer block of styrene or a monomer having a styrene structure.

The present invention (9) provides a sheet-shaped gasket having the adhesive composition according to any of (1) to (8) or an adhesive layer composed of the adhesive composition according to any of (1) to (8).

The present invention (10) provides a flooring material having an adhesive layer composed of the adhesive composition according to any of (1) to (8).

The present invention (11) provides a sealing material for inside an automotive door having an adhesive layer composed of the adhesive composition according to any of (1) to (8).

The present invention (12) provides a cushioning material for a fuel tank having an adhesive layer composed of the adhesive composition according to any of (1) to (8).

The present invention (13) provides a sealing material for an electronic component having an adhesive layer composed of the adhesive composition according to any of (1) to (8).

The present invention (14) provides a cushioning material for a lithium-ion battery having an adhesive layer composed of the adhesive composition according to any of (1) to (8).

The present invention (15) provides a sealing material between a solar cell panel and a support member of a module for a solar cell having an adhesive layer composed of the adhesive composition according to any of (1) to (8).

The present invention (16) provides a sealing material for an electronic device having an adhesive layer composed of the adhesive composition according to any of (1) to (8).

The present invention (17) provides a sealing material for an electrolytic apparatus having an adhesive layer composed of the adhesive composition according to any of (1) to (8).

The present invention (18) provides a sealing material for an electrolytic apparatus formed only of an adhesive layer composed of the adhesive composition according to any of (1) to (8).

The present invention (19) provides a sealing material for an electrolytic apparatus formed only of an adhesive layer composed of the adhesive composition according to any of (1) to (8).

### Advantageous Effect of Invention

The present invention can provide an adhesive composition for forming an adhesive layer to be provided on the surface of an elastic rubber material, which is the main material of a sealing material, a resin material, a metal material, a paper material, or a cork material, the adhesive composition capable of forming the adhesive layer with excellent adhesion both at high temperatures (80°C or higher, for example, 100°C) and at normal temperatures of about 25°C.

The present invention can provide an adhesive composition for forming an adhesive layer in a sealing material formed only of the adhesive layer composed of the adhesive composition, the adhesive composition capable of forming the adhesive layer with excellent adhesion both at high temperatures (80°C or higher, for example, 100°C) and at normal temperatures of about 25°C.

### DESCRIPTION OF EMBODIMENTS

The adhesive composition of the present invention is an adhesive composition containing:
a copolymer (A) having (a) a polymer block of an α-methylstyrene monomer and (b) a (co)polymerization block of one or more kinds of aliphatic monoolefins and/or one or more kinds of aliphatic conjugated diolefins or a partially or fully hydrogenated block of the (co)polymerization block;
a copolymer (B) having (c) a polymer block of styrene or a monomer having a styrene structure and (d) a (co)polymerization block of one or more kinds of aliphatic monoolefins and/or one or more kinds of aliphatic conjugated diolefins or a partially or fully hydrogenated block of the (co)polymerization block; and
an adhesion imparting agent (C). Note that in the present specification, "(co)polymerization" means "polymerization or copolymerization."

The adhesive composition of the present invention contains at least the copolymer (A), the copolymer (B), and the adhesion imparting agent (C).

The copolymer (A) is a copolymer having (a) a polymer block of an α-methylstyrene monomer and (b) a (co)polymerization block of one or more kinds of aliphatic olefins and/or one or more kinds of aliphatic conjugated diolefins or a partially or fully hydrogenated block thereof. In other words, in the copolymer (A), there are one or two or more block (a) parts and one or two or more block (b) parts in a copolymer molecular chain.

The block (a) is a polymer block of an α-methylstyrene monomer, and is a block formed by polymerization of α-methylstyrene (CH₂=C(CH₃)-C₆H₅). In other words, (a) the polymer block of an α-methylstyrene monomer is a part formed by polymerization using α-methylstyrene (CH₂=C(CH₃)-C₆H₅) as a monomer.

The block (b) is (b1) a (co)polymerization block of one or more kinds of aliphatic monoolefins and/or one or more kinds of aliphatic conjugated diolefins or (b2) a polymerization block formed by polymerization of one or more kinds of aliphatic monoolefins and/or one or more kinds of aliphatic conjugated diolefins, and is a block formed by hydrogenation of some or all of the double bonds after polymerization.

In other words, (b1) is a part formed by polymerization using one kind of aliphatic monoolefin as a monomer, a part formed by copolymerization using two or more kinds of aliphatic monoolefins as monomers, a part formed by polymerization using one kind of aliphatic conjugated diolefin as a monomer, a part formed by copolymerization using two or more kinds of aliphatic conjugated diolefins as monomers, or a part formed by copolymerization using one or two or more kinds of aliphatic monoolefins and one or two or more kinds of aliphatic conjugated diolefins as monomers.

In addition, (b2) is a part formed by polymerization using one kind of aliphatic conjugated diolefin as a monomer, a part formed by copolymerization using two or more kinds of aliphatic conjugated diolefins as monomers, or a part formed by copolymerization using one or two or more kinds of aliphatic monoolefins and one or two or more kinds of aliphatic conjugated diolefins as monomers, and is a part formed by hydrogenation of some or all of the double bonds after polymerization.

The aliphatic monoolefin according to the block (b) is a linear or branched aliphatic monoolefin having two or more, preferably 2 to 13 carbon atoms. Examples of the aliphatic monoolefin according to the block (b) include ethylene, propylene, 1-butene, 2-butene, isobutylene, 1-pentene, 2-pentene, 2-methyl-1-butene, 2-methyl-2-butene, 3-methyl-1-butene, 1-hexene, 2-hexene, 3-hexene, 2-methyl-1-pentene, 2-methyl-2-pentene, 4-methyl-1-pentene, 4-methyl-2-pentene, n-heptene, isoheptene, n-octene, isooctene, n-nonene, isooctene, n-decene, isodecene, n-undecene, isoundecene, and 6,10-dimethyl-1-undecene.

The aliphatic conjugated diolefin according to the block (b) is a linear or branched aliphatic conjugated diolefin having four or more, preferably 4 to 15 carbon atoms. Examples of the aliphatic conjugated diolefin according to the block (b) include 1,3-butadiene, 2-methyl-1,3-butadiene (isoprene), 2,3-dimethyl-1,3-butadiene, 1,3-pentadiene, 2-methyl-1,3-pentadiene, 3-methyl-1,3-pentadiene, 1,3-hexadiene, 1,3-cyclohexadiene, 1,3-heptadiene, 1,3-octadiene, 2-methyl-1,3-octadiene, myrcene, and (6E)-7,11-dimethyl-3-methylidenedodeca-1,6,10-triene (common name: β-farnesene).

The block (b) is preferably a copolymer block of two or more kinds of monomers selected from ethylene, propylene, 1-butene, butadiene, isoprene, 6,10-dimethyl-1-undecene, and (6E)-7,11-dimethyl-3-methylidenedodeca-1,6,10-triene or a partially or fully hydrogenated block thereof in terms of increased adhesion at normal temperatures of about 25°C.

Such a block (b) is preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iii)
   a copolymer block of ethylene and propylene,
   a copolymer block of ethylene and (conjugated) isoprene or a partially or fully hydrogenated block thereof,
   a copolymer block of propylene and (conjugated) butadiene or a partially or fully hydrogenated block thereof,
   a copolymer block of ethylene, propylene, and (conjugated) isoprene or a partially or fully hydrogenated block thereof, and
   a copolymer block of ethylene, propylene, and (conjugated) butadiene or a partially or fully hydrogenated block thereof,
   a copolymer block of ethylene, propylene, (conjugated) butadiene, and (conjugated) isoprene or a partially or fully hydrogenated block thereof, and
   a copolymer block of (conjugated) butadiene and (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof,
(vii)
   a copolymer block of ethylene, propylene, and 6,10-dimethyl-1-undecene,
   a copolymer block of ethylene, (conjugated) isoprene, and 6,10-dimethyl-1-undecene or a partially or fully hydrogenated block thereof,
   a copolymer block of propylene, (conjugated) isoprene, and 6,10-dimethyl-1-undecene or a partially or fully hydrogenated block thereof,
   a copolymer block of ethylene, propylene, (conjugated) isoprene, and 6,10-dimethyl-1-undecene or a partially or fully hydrogenated block thereof,
   a copolymer block of (conjugated) isoprene and 6,10-dimethyl-1-undecene or a partially or fully hydrogenated block thereof,
   a copolymer block of ethylene, propylene, and (6E)-7,11-dimethyl-3-methylidenedodeca-1,6,10-triene or a partially or fully hydrogenated block thereof,
   a copolymer block of ethylene, (conjugated) isoprene, and (6E)-7,11-dimethyl-3-methylidenedodeca-1,6,10-triene or a partially or fully hydrogenated block thereof,
   a copolymer block of propylene, (conjugated) isoprene, and (6E)-7,11-dimethyl-3-methylidenedodeca-1,6,10-triene or a partially or fully hydrogenated block thereof,
   a copolymer block of ethylene, propylene, (conjugated) isoprene, and (6E)-7,11-dimethyl-3-methylidenedodeca-1,6,10-triene or a partially or fully hydrogenated block thereof,
   a copolymer block of (conjugated) isoprene and (6E)-7,11-dimethyl-3-methylidenedodeca-1,6,10-triene or a partially or fully hydrogenated block thereof,
   a copolymer block of ethylene, propylene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of propylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of ethylene, propylene, (conjugated) isoprene, 6,10-dimethyl-1-undecene, and (6E)-7,11-dimethyl-3-methylidenedodeca-1,6,10-triene or a partially or fully hydrogenated block thereof, and
   a copolymer block of (conjugated) isoprene, 6,10-dimethyl-1-undecene, and (6E)-7,11-dimethyl-3-methylidenedodeca-1,6,10-triene or a partially or fully hydrogenated block thereof,
(viii)
   a polymer block of (conjugated) butadiene, and
(ix)
   a polymer block of (conjugated) isoprene.

The block (b) is more preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iii)
   a copolymer block of ethylene and propylene,
   a copolymer block of ethylene and (conjugated) isoprene or a partially or fully hydrogenated block thereof,
   a copolymer block of propylene and (conjugated) butadiene or a partially or fully hydrogenated block thereof,
   a copolymer block of ethylene, propylene, and (conjugated) isoprene or a partially or fully hydrogenated block thereof, and
   a copolymer block of ethylene, propylene, and (conjugated) butadiene or a partially or fully hydrogenated block thereof,
   a copolymer block of ethylene, propylene, (conjugated) butadiene, and (conjugated) isoprene or a partially or fully hydrogenated block thereof, and
   a copolymer block of (conjugated) butadiene and (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof,
(vii)
   a copolymer block of ethylene, propylene, and 6,10-dimethyl-1-undecene,
   a copolymer block of ethylene, (conjugated) isoprene, and 6,10-dimethyl-1-undecene or a partially or fully hydrogenated block thereof,
   a copolymer block of propylene, (conjugated) isoprene, and 6,10-dimethyl-1-undecene or a partially or fully hydrogenated block thereof,
   a copolymer block of ethylene, propylene, (conjugated) isoprene, and 6,10-dimethyl-1-undecene or a partially or fully hydrogenated block thereof,
   a copolymer block of (conjugated) isoprene and 6,10-dimethyl-1-undecene or a partially or fully hydrogenated block thereof,
   a copolymer block of ethylene, propylene, and (6E)-7,11-dimethyl-3-methylidenedodeca-1,6,10-triene or a partially or fully hydrogenated block thereof,
   a copolymer block of ethylene, (conjugated) isoprene, and (6E)-7,11-dimethyl-3-methylidenedodeca-1,6,10-triene or a partially or fully hydrogenated block thereof,
   a copolymer block of propylene, (conjugated) isoprene, and (6E)-7,11-dimethyl-3-methylidenedodeca-1,6,10-triene or a partially or fully hydrogenated block thereof,
   a copolymer block of ethylene, propylene, (conjugated) isoprene, and (6E)-7,11-dimethyl-3-methylidenedodeca-1,6,10-triene or a partially or fully hydrogenated block thereof,
   a copolymer block of (conjugated) isoprene and (6E)-7,11-dimethyl-3-methylidenedodeca-1,6,10-triene or a partially or fully hydrogenated block thereof,
   a copolymer block of ethylene, propylene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of propylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of ethylene, propylene, (conjugated) isoprene, 6,10-dimethyl-1-undecene, and (6E)-7,11-dimethyl-3-methylidenedodeca-1,6,10-triene or a partially or fully hydrogenated block thereof, and
   a copolymer block of (conjugated) isoprene, 6,10-dimethyl-1-undecene, and (6E)-7,11-dimethyl-3-methylidenedodeca-1,6,10-triene or a partially or fully hydrogenated block thereof.

The block (b) is more preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iii)
   a copolymer block of ethylene and propylene,
   a copolymer block of ethylene and (conjugated) isoprene or a partially or fully hydrogenated block thereof,
   a copolymer block of propylene and (conjugated) butadiene or a partially or fully hydrogenated block thereof,
   a copolymer block of ethylene, propylene, and (conjugated) isoprene or a partially or fully hydrogenated block thereof, and
   a copolymer block of ethylene, propylene, and (conjugated) butadiene or a partially or fully hydrogenated block thereof,
   a copolymer block of ethylene, propylene, (conjugated) butadiene, and (conjugated) isoprene or a partially or fully hydrogenated block thereof, and
   a copolymer block of (conjugated) butadiene and (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof.

The block (b) is particularly preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block.

The copolymer (A) is preferably a triblock copolymer composed of (a) a polymer block of an α-methylstyrene monomer-(b) a copolymer block of two or more kinds of monomers selected from ethylene, propylene, 1-butene, butadiene, isoprene, 6,10-dimethyl-1-undecene, and (6E)-7,11-dimethyl-3-methylidenedodeca-1,6,10-triene or a partially or fully hydrogenated block thereof-(a) a polymer block of an α-methylstyrene monomer.

The content of the α-methylstyrene unit of the copolymer (A) is 10 to 40% by mass, preferably 15 to 40% by mass, and more preferably 20 to 35% by mass on a monomer basis. When the content of the α-methylstyrene unit of the copolymer (A) is within the above range, a decrease in elastic modulus at high temperatures (80°C or higher, for example, 100°C) is reduced, and adhesion at high temperatures (80°C or higher, for example, 100°C) increases.

The copolymer (B) is a copolymer containing (c) a polymer block of styrene or a monomer having a styrene structure and (d) a (co)polymerization block of one or more kinds of aliphatic olefins and/or one or more kinds of aliphatic conjugated diolefins or a partially or fully hydrogenated block thereof. In other words, in the copolymer (B), there are one or two or more block (c) parts and one or two or more block (d) parts in a copolymer molecular chain.

The block (c) is a polymer block of styrene or a monomer having a styrene structure, and is a block formed by polymerization of styrene (CH₂=CH-C₆H₅) or a monomer having a styrene structure. In other words, (c) the polymer block of styrene or a monomer having a styrene structure is a part formed by polymerization using styrene (CH₂=CH-C₆H₅) or a monomer having a styrene structure as a monomer. Note that the monomer having a styrene structure according to the block (c) is a compound having a structure in which a "CH₂=CH-" group is bonded to the aromatic ring, and is a compound having a structure in which a hydrogen atom is bonded to the α-position of the vinyl group, and the α-position has no substituent such as an alkyl group. Therefore, the monomer having a styrene structure according to the block (c) is different from a compound having a structure in which "CH₂=CR- (R is a substituent such as an alkyl group)" is bonded to the aromatic ring, that is, a compound having a structure having a substituent such as an alkyl group at the α-position of the vinyl group.

Examples of styrene or a monomer having a styrene structure according to the block (c) include styrene, 2-methylstyrene, 3-methylstyrene, 4-methylstyrene, 4-propylstyrene, 4-isopropylstyrene, 4-n-butylstyrene, 4-t-butylstyrene, 4-n-hexylstyrene, 4-cyclohexylstyrene, 4-octylstyrene, 4-dodecylstyrene, 2,4-dimethylstyrene, 2,4-diisopropylstyrene, 2,4,6-trimethylstyrene, 1-vinylnaphthalene, 2-vinylnaphthalene, vinylanthracene, N,N-diethyl-4-aminoethylstyrene, vinylpyridine, 4-methoxystyrene, 4-vinylstyrene, and 1,1-diphenylethylene.

Examples of the block (c) include polymer blocks of styrene, and copolymer blocks of one or two or more kinds of monomers selected from styrene, 2-methylstyrene, 3-methylstyrene, 4-methylstyrene, 4-propylstyrene, 4-isopropylstyrene, 4-n-butylstyrene, 4-t-butylstyrene, 4-n-hexylstyrene, 4-cyclohexylstyrene, 4-octylstyrene, 4-dodecylstyrene, 2,4-dimethylstyrene, 2,4-diisopropylstyrene, 2,4,6-trimethylstyrene, 1-vinylnaphthalene, 2-vinylnaphthalene, vinylanthracene, N,N-diethyl-4-aminoethylstyrene, vinylpyridine, 4-methoxystyrene, 4-vinylstyrene, and 1,1-diphenylethylene.

The block (d) is (d1) a (co)polymerization block of one or more kinds of aliphatic monoolefins and/or one or more kinds of aliphatic conjugated diolefins or (d2) a polymerization block formed by polymerization of one or more kinds of aliphatic monoolefins and/or one or more kinds of aliphatic conjugated diolefins, and is a block formed by hydrogenation of some or all of the double bonds after polymerization.

In other words, (d1) is a part formed by polymerization using one kind of aliphatic monoolefin as a monomer, a part formed by copolymerization using two or more kinds of aliphatic monoolefins as monomers, a part formed by polymerization using one kind of conjugated diolefin as a monomer, a part formed by copolymerization using two or more kinds of aliphatic conjugated diolefins as monomers, or a part formed by copolymerization using one or two or more kinds of aliphatic monoolefins and one or two or more kinds of aliphatic conjugated diolefins as monomers.

In addition, (d2) is a part formed by polymerization using one kind of aliphatic conjugated diolefin as a monomer, a part formed by copolymerization using two or more kinds of aliphatic conjugated diolefins as monomers, or a part formed by copolymerization using one or two or more kinds of aliphatic monoolefins and one or two or more kinds of aliphatic conjugated diolefins as monomers, and is a part formed by hydrogenation of some or all of the double bonds after polymerization.

The aliphatic monoolefin according to the block (d) is a linear or branched aliphatic monoolefin having two or more, preferably 2 to 13 carbon atoms. Examples of the aliphatic monoolefin according to the block (b) include ethylene, propylene, 1-butene, 2-butene, isobutylene, 1-pentene, 2-pentene, 2-methyl-1-butene, 2-methyl-2-butene, 3-methyl-1-butene, 1-hexene, 2-hexene, 3-hexene, 2-methyl-1-pentene, 2-methyl-2-pentene, 4-methyl-1-pentene, 4-methyl-2-pentene, n-heptene, isoheptene, n-octene, isooctene, n-nonene, isooctene, n-decene, isodecene, n-undecene, isoundecene, and 6,10-dimethyl-1-undecene.

The aliphatic conjugated diolefin according to the block (d) is a linear or branched aliphatic conjugated diolefin having four or more, preferably 4 to 15 carbon atoms. Examples of the aliphatic conjugated diolefin according to the block (b) include 1,3-butadiene, 2-methyl-1,3-butadiene, 2,3-dimethyl-1,3-butadiene, 1,3-pentadiene, 2-methyl-1,3-pentadiene, 3-methyl-1,3-pentadiene, 1,3-hexadiene, 1,3-cyclohexadiene, 1,3-heptadiene, 1,3-octadiene, 2-methyl-1,3-octadiene, myrcene, and (6E)-7,11-dimethyl-3-methylidenedodeca-1,6,10-triene.

The block (d) is particularly preferably a copolymer block of two or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block thereof in terms of increased adhesion at normal temperatures of about 25°C.

Such a block (d) is preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iii)
   a copolymer block of ethylene and propylene,
   a copolymer block of ethylene and (conjugated) isoprene or a partially or fully hydrogenated block thereof,
   a copolymer block of propylene and (conjugated) butadiene or a partially or fully hydrogenated block thereof,
   a copolymer block of ethylene, propylene, and (conjugated) isoprene or a partially or fully hydrogenated block thereof, and
   a copolymer block of ethylene, propylene, and (conjugated) butadiene or a partially or fully hydrogenated block thereof,
   a copolymer block of ethylene, propylene, (conjugated) butadiene, and (conjugated) isoprene or a partially or fully hydrogenated block thereof, and
   a copolymer block of (conjugated) butadiene and (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof,
(vii)
   a copolymer block of ethylene, propylene, and 6,10-dimethyl-1-undecene,
   a copolymer block of ethylene, (conjugated) isoprene, and 6,10-dimethyl-1-undecene or a partially or fully hydrogenated block thereof,
   a copolymer block of propylene, (conjugated) isoprene, and 6,10-dimethyl-1-undecene or a partially or fully hydrogenated block thereof,
   a copolymer block of ethylene, propylene, (conjugated) isoprene, and 6,10-dimethyl-1-undecene or a partially or fully hydrogenated block thereof,
   a copolymer block of (conjugated) isoprene and 6,10-dimethyl-1-undecene or a partially or fully hydrogenated block thereof,
   a copolymer block of ethylene, propylene, and (6E)-7,11-dimethyl-3-methylidenedodeca-1,6,10-triene or a partially or fully hydrogenated block thereof,
   a copolymer block of ethylene, (conjugated) isoprene, and (6E)-7,11-dimethyl-3-methylidenedodeca-1,6,10-triene or a partially or fully hydrogenated block thereof,
   a copolymer block of propylene, (conjugated) isoprene, and (6E)-7,11-dimethyl-3-methylidenedodeca-1,6,10-triene or a partially or fully hydrogenated block thereof,
   a copolymer block of ethylene, propylene, (conjugated) isoprene, and (6E)-7,11-dimethyl-3-methylidenedodeca-1,6,10-triene or a partially or fully hydrogenated block thereof,
   a copolymer block of (conjugated) isoprene and (6E)-7,11-dimethyl-3-methylidenedodeca-1,6,10-triene or a partially or fully hydrogenated block thereof,
   a copolymer block of ethylene, propylene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of propylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of ethylene, propylene, (conjugated) isoprene, 6,10-dimethyl-1-undecene, and (6E)-7,11-dimethyl-3-methylidenedodeca-1,6,10-triene or a partially or fully hydrogenated block thereof, and
   a copolymer block of (conjugated) isoprene, 6,10-dimethyl-1-undecene, and (6E)-7,11-dimethyl-3-methylidenedodeca-1,6,10-triene or a partially or fully hydrogenated block thereof,
(viii)
   a polymer block of (conjugated) butadiene, and
(ix)
   a polymer block of (conjugated) isoprene.

The block (d) is more preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iii)
   a copolymer block of ethylene and propylene,
   a copolymer block of ethylene and (conjugated) isoprene or a partially or fully hydrogenated block thereof,
   a copolymer block of propylene and (conjugated) butadiene or a partially or fully hydrogenated block thereof,
   a copolymer block of ethylene, propylene, and (conjugated) isoprene or a partially or fully hydrogenated block thereof, and
   a copolymer block of ethylene, propylene, and (conjugated) butadiene or a partially or fully hydrogenated block thereof,
   a copolymer block of ethylene, propylene, (conjugated) butadiene, and (conjugated) isoprene or a partially or fully hydrogenated block thereof, and
   a copolymer block of (conjugated) butadiene and (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof,
(vii)
   a copolymer block of ethylene, propylene, and 6,10-dimethyl-1-undecene,
   a copolymer block of ethylene, (conjugated) isoprene, and 6,10-dimethyl-1-undecene or a partially or fully hydrogenated block thereof,
   a copolymer block of propylene, (conjugated) isoprene, and 6,10-dimethyl-1-undecene or a partially or fully hydrogenated block thereof,
   a copolymer block of ethylene, propylene, (conjugated) isoprene, and 6,10-dimethyl-1-undecene or a partially or fully hydrogenated block thereof,
   a copolymer block of (conjugated) isoprene and 6,10-dimethyl-1-undecene or a partially or fully hydrogenated block thereof,
   a copolymer block of ethylene, propylene, and (6E)-7,11-dimethyl-3-methylidenedodeca-1,6,10-triene or a partially or fully hydrogenated block thereof,
   a copolymer block of ethylene, (conjugated) isoprene, and (6E)-7,11-dimethyl-3-methylidenedodeca-1,6,10-triene or a partially or fully hydrogenated block thereof,
   a copolymer block of propylene, (conjugated) isoprene, and (6E)-7,11-dimethyl-3-methylidenedodeca-1,6,10-triene or a partially or fully hydrogenated block thereof,
   a copolymer block of ethylene, propylene, (conjugated) isoprene, and (6E)-7,11-dimethyl-3-methylidenedodeca-1,6,10-triene or a partially or fully hydrogenated block thereof,
   a copolymer block of (conjugated) isoprene and (6E)-7,11-dimethyl-3-methylidenedodeca-1,6,10-triene or a partially or fully hydrogenated block thereof,
   a copolymer block of ethylene, propylene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of propylene, (conjugated) isoprene, 6,10-dimethyl-1-undecene, and (6E)-7,11-dimethyl-3-methylidenedodeca-1,6,10-triene or a partially or fully hydrogenated block thereof,
   a copolymer block of ethylene, propylene, (conjugated) isoprene, 6,10-dimethyl-1-undecene, and (6E)-7,11-dimethyl-3-methylidenedodeca-1,6,10-triene or a partially or fully hydrogenated block thereof, and
   a copolymer block of (conjugated) isoprene, 6,10-dimethyl-1-undecene, and (6E)-7,11-dimethyl-3-methylidenedodeca-1,6,10-triene or a partially or fully hydrogenated block thereof.

The block (d) is more preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iii)
   a copolymer block of ethylene and propylene,
   a copolymer block of ethylene and (conjugated) isoprene or a partially or fully hydrogenated block thereof,
   a copolymer block of propylene and (conjugated) butadiene or a partially or fully hydrogenated block thereof,
   a copolymer block of ethylene, propylene, and (conjugated) isoprene or a partially or fully hydrogenated block thereof, and
   a copolymer block of ethylene, propylene, and (conjugated) butadiene or a partially or fully hydrogenated block thereof,
   a copolymer block of ethylene, propylene, (conjugated) butadiene, and (conjugated) isoprene or a partially or fully hydrogenated block thereof, and
   a copolymer block of (conjugated) butadiene and (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof.

The block (d) is particularly preferably
(i)
   a copolymer block of ethylene and 1-butene,
   a copolymer block of ethylene and (conjugated) butadiene or a partially or fully hydrogenated block thereof,
   a copolymer block of 1-butene and (conjugated) butadiene or a partially or fully hydrogenated block thereof,
   a copolymer block of ethylene, 1-butene, and (conjugated) butadiene or a partially or fully hydrogenated block thereof, and
   a polymer block of (conjugated) butadiene or a partially or fully hydrogenated block thereof,
(ii)
   a copolymer block of ethylene and propylene,
   a copolymer block of ethylene and (conjugated) isoprene or a partially or fully hydrogenated block thereof,
   a copolymer block of propylene and (conjugated) isoprene or a partially or fully hydrogenated block thereof,
   a copolymer block of ethylene, propylene, and (conjugated) isoprene or a partially or fully hydrogenated block thereof, and
   a polymer block of (conjugated) isoprene or a partially or fully hydrogenated block thereof,
(iv)
   a polymer block of isobutylene,
(v)
   a copolymer block of ethylene and 6,10-dimethyl-1-undecene,
   a copolymer block of ethylene, 6,10-dimethyl-1-undecene, and (6E)-7,11-dimethyl-3-methylidenedodeca-1,6,10-triene or a partially or fully hydrogenated block thereof, and
   a polymer block of (6E)-7,11-dimethyl-3-methylidenedodeca-1,6,10-triene or a partially or fully hydrogenated block thereof,
(vi)
   a copolymer block of ethylene, 1-butene, and 6,10-dimethyl-1-undecene,
   a copolymer block of ethylene, (conjugated) butadiene, and 6,10-dimethyl-1-undecene or a partially or fully hydrogenated block thereof,
   a copolymer block of 1-butene, (conjugated) butadiene, and 6,10-dimethyl-1-undecene or a partially or fully hydrogenated block thereof,
   a copolymer block of ethylene, 1-butene, (conjugated) butadiene, and 6,10-dimethyl-1-undecene or a partially or fully hydrogenated block thereof,
   a copolymer block of (conjugated) butadiene and 6,10-dimethyl-1-undecene or a partially or fully hydrogenated block thereof,
   a copolymer block of ethylene, 1-butene, and (6E)-7,11-dimethyl-3-methylidenedodeca-1,6,10-triene or a partially or fully hydrogenated block thereof,
   a copolymer block of ethylene, (conjugated) butadiene, and (6E)-7,11-dimethyl-3-methylidenedodeca-1,6,10-triene or a partially or fully hydrogenated block thereof,
   a copolymer block of 1-butene, (conjugated) butadiene, and (6E)-7,11-dimethyl-3-methylidenedodeca-1,6,10-triene or a partially or fully hydrogenated block thereof,
   a copolymer block of ethylene, 1-butene, (conjugated) butadiene, and (6E)-7,11-dimethyl-3-methylidenedodeca-1,6,10-triene or a partially or fully hydrogenated block thereof,
   a copolymer block of (conjugated) butadiene and (6E)-7,11-dimethyl-3-methylidenedodeca-1,6,10-triene or a partially or fully hydrogenated block thereof,
   a copolymer block of ethylene, 1-butene, 6,10-dimethyl-1-undecene, and (6E)-7,11-dimethyl-3-methylidenedodeca-1,6,10-triene or a partially or fully hydrogenated block thereof,
   a copolymer block of ethylene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of 1-butene, (conjugated) butadiene, 6,10-dimethyl-1-undecene, and (6E)-7,11-dimethyl-3-methylidenedodeca-1,6,10-triene or a partially or fully hydrogenated block thereof,
   a copolymer block of ethylene, 1-butene, (conjugated) butadiene, 6,10-dimethyl-1-undecene, and (6E)-7,11-dimethyl-3-methylidenedodeca-1,6,10-triene or a partially or fully hydrogenated block thereof, and
   a copolymer block of (conjugated) butadiene, 6,10-dimethyl-1-undecene, and (6E)-7,11-dimethyl-3-methylidenedodeca-1,6,10-triene or a partially or fully hydrogenated block thereof.

The copolymer (B) is preferably a triblock copolymer composed of (c) a polymer block of styrene or a monomer having a styrene structure-(d) a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block thereof-(c) a polymer block of styrene or a monomer having a styrene structure, and may contain a diblock copolymer composed of (c) a polymer block of styrene or a monomer having a styrene structure-(d) a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block thereof.

The content of the unit composed of styrene or a monomer having a styrene structure of the copolymer (B) is 5 to 25% by mass, and preferably 12 to 21% by mass on a monomer basis. When the content of the unit composed of styrene or a monomer having a styrene structure of the copolymer (B) is within the above range, adhesion at normal temperatures of about 25°C increases.

The adhesion imparting agent (C) enhances the adhesion of the adhesive layer, and examples thereof include phenolic resins, terpene-based resins, rosin-based resins, hydrogenated rosin-based resins, coumarone-based resins, terpene phenolic resins, hydrogenated terpene phenolic resins, aromatic hydrocarbon resins, aliphatic hydrocarbon resins, and xylene-formaldehyde resins. More specifically, examples of the adhesion imparting agent (C) include terpene resins, terpene phenolic resins, hydrogenated terpene resins, hydrogenated terpene phenolic resins, aromatic hydrocarbon resins, aliphatic hydrocarbon resins, and xylene-formaldehyde resins. The adhesion imparting agent (C) is preferably one or more kinds selected from terpene phenolic resins, hydrogenated terpene phenolic resins, phenolic resins, xylene-formaldehyde resins, rosin-based resins, and hydrogenated rosin-based resins.

The softening point of the adhesion imparting agent (C) is preferably 80 to 170°C, and more preferably 100 to 145°C. The hydroxyl value of the adhesion imparting agent (C) is preferably 5 to 200 mgKOH/g, and more preferably 10 to 120 mgKOH/g.

In the adhesive composition of the present invention, the ratio of the content of the copolymer (A) to the total content of the copolymer (A) and the copolymer (B) ((copolymer (A)/(copolymer (A) + copolymer (B))) × 100) is 5 to 95% by mass, preferably 10 to 90% by mass, more preferably 20 to 80% by mass, and more preferably 25 to 75% by mass. When the ratio of the content of the copolymer (A) to the total content of the copolymer (A) and the copolymer (B) is within the above range, it is possible to achieve both high adhesion at high temperatures (80°C or higher, for example, 100°C) and high adhesion at normal temperatures of about 25°C.

In the adhesive composition of the present invention, the ratio of the content of the adhesion imparting agent (C) to the total content of the copolymer (A) and the copolymer (B) ((adhesion imparting agent (C)/(copolymer (A) + copolymer (B))) × 100) is 5 to 100% by mass, preferably 10 to 70% by mass, and more preferably 30 to 50% by mass. When the ratio of the content of the adhesion imparting agent (C) to the total content of the copolymer (A) and the copolymer (B) is within the above range, it is possible to achieve both high adhesion at high temperatures (80°C or higher, for example, 100°C) and high adhesion at normal temperatures of about 25°C.

The adhesive composition of the present invention can contain an antioxidant (D) in addition to the copolymer (A), the copolymer (B), and the adhesion imparting agent (C). Examples of the antioxidant (D) include amine-based, phenolic, benzimidazole-based, phosphoric acid-based, and organic thio acid-based antioxidants.

When the adhesive composition of the present invention contains the antioxidant (D), the ratio of the content of the antioxidant (D) to the total content of the copolymer (A) and the copolymer (B) ((antioxidant (D)/(copolymer (A) + copolymer (B))) × 100) is 0.10 to 1.0% by mass, preferably 0.15 to 0.75% by mass, and more preferably 0.25 to 0.50% by mass. When the ratio of the content of the antioxidant (D) to the total content of the copolymer (A) and the copolymer (B) is within the above range, a decrease in adhesion caused by degradation due to heat or light can be reduced.

The adhesive composition of the present invention can contain various additives used in adhesive compositions in addition to the copolymer (A), the copolymer (B), and the adhesion imparting agent (C) as needed to the extent that the effects of the present invention are not impaired.

The adhesive composition of the present invention can contain a leveling agent (surface active agent) (E) as an additive. Examples of the leveling agent (surface active agent) (E) include silicone-based leveling agents such as polyester-modified silicones, polyether-modified silicones, polyether-polyester-modified silicones, silicone-modified (meth)acrylic resins, carbinol-modified silicones, amino-modified silicones, polydimethylsiloxanes modified with carboxyl, ether, epoxy, and the like, alkyl-modified silicones, alkyl-aralkyl-modified silicones, higher fatty acid ester-modified silicones, phenyl-modified silicones, carboxyl-modified silicones, epoxy-modified silicones, and fluorine-modified silicones; straight silicones such as polydimethylsiloxane, polyphenylsiloxane, polymethylphenylsiloxane, and polymethylhydrogensiloxane; acrylic polymers such as acrylic polymers, silicone-modified acrylic polymers, fluorine-modified acrylic polymers, (meth)acrylic copolymers, and polyether-modified (meth)acrylic compounds; fluorine-based leveling agents such as perfluoroalkenyl carboxylates, perfluoroalkenyl sulfonates, perfluoroalkenyl phosphates, perfluoroalkyl polyoxyethylene ethers, perfluoroalkyl carboxylates, perfluoroalkyl sulfonates, and perfluoroalkyl phosphates; vinyl-based polymers such as vinyl ether-based polymers; acetylene glycol-based leveling agents; and olefin-based polymers such as olefin-based polymers such as low molecular weight polyethylenes and low molecular weight polypropylenes, ethylene-(meth)acrylic copolymers, and modified-olefin-based polymers such as acid-modified polyolefins. Other examples of the leveling agent (surface active agent) include nonionic surfactants, anionic surfactants, cationic surfactants, amphoteric surfactants, nonionic surfactants, fluorine-based surfactants, alkoxylated surfactants, hyperbranched polyethers, sulfosuccinates, tetramethyldecanediols, and alkoxyl-modified tetramethyldecanediols.

The adhesive composition of the present invention is obtained by mixing the copolymer (A), the copolymer (B), the adhesion imparting agent (C), and as needed, the antioxidant (D) and the like in a solvent, then mixing, stirring, or kneading the mixture using a stirrer, then applying the mixture to an object to form the adhesive layer, and then removing the solvent by heating.

The solvent is not limited to a particular solvent, and examples thereof include aliphatic hydrocarbon-based, aromatic hydrocarbon-based, ketone-based, ester-based, ether-based, and alcohol-based solvents, with aromatic hydrocarbon-based solvents being preferred. The amount of the solvent used is selected as appropriate in accordance with use, the method of application, and application thickness.

The copolymer (A) has a high elastic modulus at temperatures higher than 100°C, and has excellent adhesion at high temperatures when combined with the adhesion imparting agent (C). The copolymer (B) has flexible properties at normal temperatures of about 25°C, and has excellent adhesion at normal temperatures of about 25°C when combined with the adhesion imparting agent (C). Therefore, the adhesive composition of the present invention, containing (A), (B) and (C), is an adhesive composition with excellent adhesion over a wide temperature range.

Syrene-based block copolymers represented by poly(styrene-butadiene-styrene) are known as thermoplastic elastomers. The polystyrene block is called a hard segment and is in a glassy state at normal temperatures, while the polybutadiene block is called a soft segment and is in a rubbery state at normal temperatures. A styrene-based thermoplastic elastomer, in which the hard segments act as cross-linking points, exhibits rubber elasticity at normal temperatures. However, since the glass transition temperature of polystyrene resides near 100°C, it loses its rubber elasticity at temperatures higher than 100°C, resulting in a decrease in elastic modulus. On the other hand, poly(α-methylstyrene) contained in the copolymer (A) has a higher glass transition temperature than that of polystyrene, and the copolymer (A) is less likely to decrease in elastic modulus at temperatures higher than 100°C. Therefore, the adhesive composition of the present invention is an adhesive composition with excellent adhesion at high temperatures (80°C or higher, for example, 100°C) when the copolymer (A) is contained.

On the other hand, if the copolymer (A) is contained without being combined with (B), elastic modulus at normal temperatures of about 25°C becomes higher, resulting in decreased adhesion.

Given these circumstances, in the adhesive composition of the present invention, the ratio of the content of the copolymer (A) to the total content of the copolymer (A) and the copolymer (B) ((copolymer (A)/(copolymer (A) + copolymer (B))) × 100) is 5 to 95% by mass, preferably 10 to 90% by mass, preferably 20 to 80% by mass, and more preferably 25 to 75% by mass, so that flexibility is maintained even at normal temperatures of about 25°C. Thus, the adhesive composition of the present invention is an adhesive composition with excellent adhesion at normal temperatures of about 25°C when the copolymer (B) is contained. However, when the copolymer (B) is contained without being combined with (A), adhesion at temperatures higher than 100°C almost disappears.

As described above, the present invention can provide an adhesive composition with excellent adhesion over a wide temperature range by combining the copolymer (A) with excellent adhesion at high temperatures, (B) with excellent adhesion at low temperatures, and the adhesion imparting agent (C).

The adhesive composition of the present invention can contain one or more kinds of copolymers (F) that are aromatic copolymers selected from polyphenylene ether copolymers, styrene-maleic anhydride copolymers, styrene-N-phenylmaleimide copolymers, and styrene-N-phenylmaleimide copolymers-maleic anhydride copolymers, and have a glass transition temperature of 140°C or higher.

In the adhesive composition of the present invention, the content of the copolymer (F) is 0 to 50% by mass, preferably 0 to 30% by mass, and more preferably 0 to 20% by mass with respect to the copolymer (A).

The adhesive composition of the present invention is used in order to enhance adhesion to an object to be sealed such as an elastic rubber material, which is the main material of gaskets, sealing materials, and the like, a resin material, a metal material, a paper material, or a cork material. Therefore, the adhesive composition of the present invention is formed on the surface of the elastic rubber material, which is the main material of gaskets, sealing materials, and the like, the resin material, the metal material, the paper material, or the cork material.

Examples of use for the adhesive composition of the present invention include adhesive layers formed on a sheet-shaped gasket, a flooring material, a sealing material for inside an automotive door, a cushioning material for a fuel tank, a sealing material for an electronic component, a cushioning material for a lithium-ion battery, a sealing material between a solar cell panel and a support member of a module for a solar cell, a sealing material for an electronic device, a sealing material for an electrolytic apparatus, and the like.

The sheet-shaped gasket of the present invention is a sheet-shaped gasket having an adhesive layer composed of the adhesive composition of the present invention. Examples of the sheet-shaped gasket of the present invention include sheet-shaped gaskets having a sheet-shaped elastic rubber material, resin material, metal material, paper material, or cork material and the adhesive layer composed of the adhesive composition of the present invention formed on the surface of the elastic rubber material, the resin material, the metal material, the paper material, or the cork material. The sheet-shaped elastic rubber material may have a metal sheet or resin sheet inside or does not necessarily have a metal sheet or resin sheet. The elastic rubber material, the resin material, the metal material, the paper material, the cork material, or the like for use in the sheet-shaped gasket of the present invention may be provided with a primer layer to further improve adhesive strength.

The flooring material of the present invention is a flooring material having an adhesive layer composed of the adhesive composition of the present invention. Examples of the flooring material of the present invention include flooring materials having an elastic rubber material, a resin material, a paper material, or a cork material and the adhesive layer composed of the adhesive composition of the present invention formed on the surface of the elastic rubber material, the resin material, the paper material, or the cork material.

The sealing material for inside an automotive door of the present invention is a sealing material for inside an automotive door having an adhesive layer composed of the adhesive composition of the present invention. Examples of the sealing material for inside an automotive door of the present invention include sealing materials inside an automotive door having an elastic rubber material, a resin material, a paper material, or a cork material and the adhesive layer composed of the adhesive composition of the present invention formed on the surface of the elastic rubber material, the resin material, the paper material, or the cork material.

The cushioning material for a fuel tank of the present invention is a cushioning material for a fuel tank having an adhesive layer composed of the adhesive composition of the present invention. Examples of the cushioning material for a fuel tank of the present invention include cushioning materials for a fuel tank having an elastic rubber material, a resin material, a paper material, or a cork material and the adhesive layer composed of the adhesive composition of the present invention formed on the surface of the elastic rubber material, the resin material, the paper material, or the cork material.

The sealing material for an electronic component of the present invention is a sealing material for an electronic component having an adhesive layer composed of the adhesive composition of the present invention. Examples of the sealing material for an electronic component of the present invention include sealing materials for an electronic component having an elastic rubber material, a resin material, a paper material, or a cork material and the adhesive layer composed of the adhesive composition of the present invention formed on the surface of the elastic rubber material, the resin material, the paper material, or the cork material.

The cushioning material for a lithium-ion battery of the present invention is a cushioning material for a lithium-ion battery having an adhesive layer composed of the adhesive composition of the present invention. Examples of the cushioning material for a lithium-ion battery of the present invention include cushioning materials for a lithium-ion battery having an elastic rubber material, a resin material, a paper material, or a cork material and the adhesive layer composed of the adhesive composition of the present invention formed on the surface of the elastic rubber material, the resin material, the paper material, or the cork material.

The sealing material between a solar cell panel and a support member of a module for a solar cell of the present invention is a sealing material between a solar cell panel and a support member of a module for a solar cell having an adhesive layer composed of the adhesive composition of the present invention. Examples of the sealing material between a solar cell panel and a support member of a module for a solar cell of the present invention include sealing materials between a solar cell panel and a support member of a module for a solar cell having an elastic rubber material, a resin material, a paper material, or a cork material and the adhesive layer composed of the adhesive composition of the present invention formed on the surface of the elastic rubber material, the resin material, the paper material, or the cork material.

The sealing material for an electronic device of the present invention is a sealing material for an electronic device having an adhesive layer composed of the adhesive composition of the present invention. Examples of the sealing material for an electronic device of the present invention include sealing materials for an electronic device having an elastic rubber material, a resin material, a paper material, or a cork material and the adhesive layer composed of the adhesive composition of the present invention formed on the surface of the elastic rubber material, the resin material, the paper material, or the cork material.

The sealing material for an electrolytic apparatus of the present invention is a sealing material for an electrolytic apparatus having an adhesive layer composed of the adhesive composition of the present invention. Examples of the sealing material for an electrolytic apparatus of the present invention include sealing materials for an electrolytic apparatus having an elastic rubber material, a resin material, a paper material, or a cork material and the adhesive layer composed of the adhesive composition of the present invention formed on the surface of the elastic rubber material, the resin material, the paper material, or the cork material.

In the present invention, examples of the elastic rubber material include solid rubber materials and foam rubber materials.

Examples of the material of the solid rubber include rubbers such as natural rubber (NR), butadiene rubber (BR), isoprene rubber (IR), butyl rubber (IIR), ethylene propylene rubber (EPM), ethylene propylene diene rubber (EPDM), ethylene butylene diene rubber (EBDM), nitrile butadiene rubber (NBR), styrene butadiene rubber (SBR), chloroprene rubber, urethane rubber, acrylic rubber, silicone rubber, fluorine rubber, or hydrogenated products thereof. In addition, olefin-based, styrene-based, urethane-based, ester-based, and amide-based thermoplastic elastomers can also be used, and the above-described rubbers and the thermoplastic elastomers may be mixed.

The foam rubber is a porous rubber. Examples of the foam rubber include spongy foam rubbers having an open-cell structure, foam rubbers having a closed-cell structure, and semi-closed-cell foam rubbers. Specific examples of the material of the foam rubber include rubbers such as natural rubber (NR), butadiene rubber (BR), isoprene rubber (IR), butyl rubber (IIR), ethylene propylene rubber (EPM), ethylene propylene diene rubber (EPDM), ethylene butylene diene rubber (EBDM), nitrile butadiene rubber (NBR), styrene butadiene rubber (SBR), chloroprene rubber, urethane rubber, acrylic rubber, silicone rubber, fluorine rubber, or hydrogenated products thereof. In addition, olefin-based, styrene-based, urethane-based, ester-based, and amide-based thermoplastic elastomers can also be used, and the above-described rubbers and the thermoplastic elastomers may be mixed.

In the present invention, the resin material includes thermoplastic resins such as general-purpose resins such as polyethylene, polypropylene, polystyrene, acrylonitrile/butadiene/styrene resins (ABS resins), polyvinyl chloride resins, acrylonitrile/styrene resins, methacrylic resins, and vinyl chloride resins, general-purpose engineering resins such as polyamide, polyacetal, polycarbonate, modified-polyphenylene ether, polyethylene terephthalate, polybutylene terephthalate, and polyethylene naphthalate, and super engineering resins such as polyphenylene sulfide, polyimide, polyetherimide, polyarylate, polysulfone, polyether ether ketone, and liquid crystal polymers, and thermosetting resins such as phenolic resins, urea resins, melamine resins, unsaturated polyester resins, and epoxy resins, which are selected as appropriate in accordance with use for the sealing material.

The sealing material of the present invention includes, as a sealing material formed only of an adhesive layer composed of the adhesive composition of the present invention, a sealing material formed only of an adhesive layer composed of the adhesive composition of the present invention without a base material such as an elastic rubber material, a resin material, a metal material, a paper material, or a cork material.

The present invention will be described below in more detail by means of examples and comparative examples, but the present invention is not limited in any way by the following examples.

### [Examples]

### (Examples and Comparative Examples)

### <Production of Adhesive Solution>

Into a pail with a capacity of 1 L, 280 g of the copolymer A listed in Table 1 and 520 g of a solvent were weighed and stirred at 250 to 300 rpm for 4 hours or longer using a three-one motor to make a 35% solution (a solution A). The copolymer B (B1 to B5) listed in Table 1 was also made into a 35% solution (a solution B) in the same manner. Into a polypropylene lidded container, 140 g of the adhesion imparting agent C (C1 to C5) listed in Table 1 and 260 g of a solvent were weighed, and shaken and dissolved to make a 35% solution (a solution C).

The solution A, the solution B, and the solution C were mixed together to achieve the blend ratios and concentrations listed in Table 2 to Table 4, and stirred at 500 rpm for 1 to 5 minutes using a three-one motor to make an adhesive solution. Note that the concentration was adjusted by adding a solvent as appropriate to bring the adhesive solution into a range of 24 to 25%.

### <Production of Adhesive Film>

A resin film was cut to be 150 mm long and 300 mm wide. In this case, the length direction was regarded as top and bottom, and the width direction as left and right. Being fixed to a rigid plate such as a metal plate, the film was erected vertically, and the adhesive solution was poured from the top of the film to apply it. The coated film was placed in a high-temperature constant-temperature machine to thoroughly dry the solvent to make an adhesive film. The thickness of the 80 mm part from the bottom end of the film of the adhesive was measured with a micrometer to determine it as an adhesive thickness. Note that the material of the resin film may be selected from polyethylene terephthalate, polyethylene naphthalate, polyvinyl chloride, polystyrene, syndiotactic polystyrene, and polyimide, and surface treatment may be applied as needed.

### <Cutting out of Adhesive Film for Peel Test>

The adhesive film was cut by 20 mm from the top end and by 5 mm from the left and right ends and the bottom end to make a film 125 mm long and 290 mm wide. This film was cut out to be 125 mm long and 25 mm wide to make an adhesive film for peel test.

### <Compression Bonding of Adhesive Film for Peel Test>

The adhesive film for peel test and an adherend (a stainless steel plate) are compression bonded together. The adherend cut out to be 75 mm long and 25 mm wide was cleaned with ethanol. Then, the bottom ends of the adherend and the adhesive film for peel test were aligned with each other and pasted together to prevent air from entering. The test piece was placed with the adherend being the upper surface, and a metal roller was moved back and forth three times in a direction of the length of the adherend to perform compression bonding. The metal roller weighed 1.83 kg, and compression bonding was performed by its own weight.

### <180-Degree Peel Test>

A universal testing machine (manufactured by Shimadzu Corporation, Autograph AGS-500NX) was used for a 180-degree peel test to measure adhesion. A jig with chucks for tensile test was attached to the testing machine, and the distance between chucks was set to 60 mm. The top 25 mm of the test piece was peeled off from the adherend, and that part was used as a handle for the peel test. The adherend end was gripped by the lower chuck and the adhesive film end was gripped by the upper chuck. Then, the crosshead was raised at a speed of 100 mm/min to peel off the adhesive film in a 180-degree direction. The test was conducted at test temperatures of 25°C, 80°C, 100°C, and 120°C. When the test was conducted at test temperatures of 80°C or higher, the peel test was conducted while being heated in a thermostatic chamber.

A value obtained by dividing a test force [N] in the peel test by 25 mm width was measured as peel strength [N/mm], and for each measurement result, a relative value when the peel strength at 80°C in Comparative Example 9 was set to "1.00" was calculated. Table 2 to Table 4 list the results.

**[Table 1]**

| | | Material name | Styrene ratio | Softening point [°C] | Hydroxyl value [mgKOH/g] (reference value) |
|---|---|---|---|---|---|
| Copolymer A | A1 | Hydrogenated product of α-methylstyrene-butadiene block copolymer | 29% | - | - |
| Copolymer B | B1 | Styrene-isobutylene block copolymer | 15% | - | - |
| | B2 | Hydrogenated product of styrene-butadiene block copolymer | 20% | - | - |
| | B3 | Hydrogenated product of styrene-butadiene block copolymer | 20% | - | - |
| | B4 | Hydrogenated product of styrene-isoprene block copolymer | 13% | - | - |
| | B5 | Hydrogenated product of styrene-farnesene-butadiene block copolymer | 21% | - | - |
| Adhesion imparting agent C | C1 | Terpene phenolic resin | - | 100 | 50 to 60 |
| | C2 | Terpene phenolic resin | - | 115 | 20 to 30 |
| | C3 | Terpene phenolic resin | - | 130 | 50 to 60 |
| | C4 | Hydrogenated terpene phenolic resin | - | 130 | 50 to 60 |
| | C5 | Terpene phenolic resin | - | 145 | 50 to 60 |

A1: Hydrogenated product of α-methylstyrene-butadiene block copolymer, content of α-methylstyrene unit (monomer basis): 29% by mass
B1: Styrene-isobutylene block copolymer, content of styrene unit (monomer basis): 15% by mass
B2: Hydrogenated product of styrene-butadiene block copolymer, content of styrene unit (monomer basis): 20% by mass
B3: Hydrogenated product of styrene-butadiene block copolymer, content of styrene unit (monomer basis): 20% by mass
B4: Hydrogenated product of styrene-isoprene block copolymer, content of styrene unit (monomer basis): 13% by mass
B5: Hydrogenated product of styrene-farnesene-butadiene block copolymer, content of styrene unit (monomer basis): 21% by mass
C1: Terpene phenolic resin
C2: Terpene phenolic resin
C3: Terpene phenolic resin
C4: Hydrogenated terpene phenolic resin
C5: Terpene phenolic resin

**[Table 2]**

| No. | | | Ex. 1 | Ex. 2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 |
|---|---|---|---|---|---|---|---|---|---|---|---|---|---|---|---|
| Formulation [parts by mass] | Copolymer A | A1 | 90 | 80 | 70 | 60 | 50 | 40 | 30 | 20 | 10 | 50 | 50 | 50 | 50 |
| | Copolymer B | B1 | 10 | 20 | 30 | 40 | 50 | 60 | 70 | 80 | 90 | | | | |
| | | B2 | | | | | | | | | | 50 | | | |
| | | B3 | | | | | | | | | | | 50 | | |
| | | B4 | | | | | | | | | | | | 50 | |
| | | B5 | | | | | | | | | | | | | 50 |
| | Adhesion imparting agent C | C1 | | | | | | | | | | | | | |
| | | C2 | 50 | 50 | | | | | | | | | | | |
| | | C3 | | | | | | | | | | | | | |
| | | C4 | | | 30 | 30 | 30 | 30 | 30 | 30 | 30 | 30 | 30 | 30 | 30 |
| | | C5 | | | | | | | | | | | | | |
| Copolymer A content rate % by mass | A/(A + B) | | 90.0 % | 80.0 % | 70.0 % | 60.0 % | 50.0 % | 40.0 % | 30.0 % | 20.0 % | 10.0 % | 50.0 % | 50.0 % | 50.0 % | 50.0 % |
| | A/total mass | | 60.0 % | 53.3 % | 53.8 % | 46.2 % | 38.5 % | 30.8 % | 23.1 % | 15.4 % | 7.7% | 38.5 % | 38.5 % | 38.5 % | 38.5 % |
| Peel strength | 25°C | | 1.00 | 1.36 | 1.36 | 2.91 | 6.27 | 5.55 | 6.18 | 6.09 | 6.45 | 1.82 | 5.09 | 4.18 | 4.27 |
| | 80°C | | 2.36 | 2.55 | 2.73 | 2.91 | 3.73 | 4.00 | 4.36 | 4.55 | 3.09 | 2.09 | 1.18 | 1.45 | 1.91 |
| | 100°C | | 3.00 | 3.55 | 3.27 | 3.36 | 3.36 | 3.27 | 4.18 | 4.09 | 3.55 | 3.27 | 1.36 | 3.55 | 3.18 |
| | 120°C | | 4.45 | 3.73 | 3.27 | 3.64 | 2.73 | 1.82 | 2.00 | 1.64 | 2.18 | 2.45 | 2.64 | 1.09 | 1.45 |

**[Table 3]**

| No. | | | Ex. 14 | Ex. 15 | Ex. 16 | Ex. 17 | Ex. 18 | Ex. 19 | Ex. 20 | Ex. 21 | Ex. 22 | Ex. 23 | Ex. 24 | Ex. 25 | Ex. 26 | Ex. 27 | Ex. 28 |
|---|---|---|---|---|---|---|---|---|---|---|---|---|---|---|---|---|---|
| Formulation [parts by mass] | Copolymer A | A1 | 50 | 50 | 50 | 50 | 40 | 40 | 40 | 40 | 40 | 50 | 50 | 50 | 50 | 50 | 50 |
| | Copolymer B | B1 | 10 | 20 | 30 | 40 | 10 | 20 | 30 | 40 | 50 | 50 | 50 | 50 | 50 | 50 | 50 |
| | | B2 | | | | | | | | | | | | | | | |
| | | B3 | 40 | 30 | 20 | 10 | 50 | 40 | 30 | 20 | 10 | | | | | | |
| | | B4 | | | | | | | | | | | | | | | |
| | | B5 | | | | | | | | | | | | | | | |
| | Adhesion imparting agent C | C1 | | | | | | | | | | 30 | | | | | |
| | | C2 | | | | | | | | | | | 30 | 50 | | | |
| | | C3 | | | | | | | | | | | | | 30 | | |
| | | C4 | 30 | 30 | 30 | 30 | 30 | 30 | 30 | 30 | 30 | | | | | 30 | |
| | | C5 | | | | | | | | | | | | | | | 30 |
| Copolymer A content rate % by mass | A/(A + B) | | 50.0% | 50.0% | 50.0% | 50.0% | 40.0% | 40.0% | 40.0% | 40.0% | 40.0% | 50.0% | 50.0% | 50.0% | 50.0% | 50.0% | 50.0% |
| | A/total mass | | 38.5% | 38.5% | 38.5% | 38.5% | 30.8% | 30.8% | 30.8% | 30.8% | 30.8% | 38.5% | 38.5% | 33.3% | 38.5% | 38.5% | 38.5% |
| Peel strength | 25°C | | 3.18 | 4.73 | 5.73 | 3.27 | 5.55 | 4.82 | 5.73 | 5.27 | 5.64 | 5.09 | 6.18 | 3.82 | 4.82 | 5.55 | 1.64 |
| | 80°C | | 1.55 | 2.00 | 2.55 | 2.18 | 2.36 | 2.27 | 2.73 | 2.55 | 2.36 | 2.36 | 1.18 | 3.36 | 2.91 | 2.64 | 3.18 |
| | 100°C | | 3.00 | 2.82 | 3.00 | 3.18 | 4.18 | 3.45 | 3.18 | 3.82 | 3.45 | 3.09 | 2.27 | 4.09 | 3.73 | 3.27 | 3.91 |
| | 120°C | | 2.00 | 1.91 | 2.36 | 3.18 | 1.09 | 1.36 | 2.18 | 1.82 | 1.55 | 2.73 | 2.36 | 1.64 | 3.27 | 3.18 | 3.36 |

**[Table 4]**

| No. | | | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 | Comp. Ex. 9 | Comp. Ex. 10 | Comp. Ex. 11 | Comp. Ex. 12 | Comp. Ex. 13 | Comp. Ex. 14 |
|---|---|---|---|---|---|---|---|---|---|---|---|---|---|---|---|---|
| Formulation [parts by mass] | Copolymer A | A1 | | | | | 100 | 100 | 100 | 100 | 100 | 100 | 100 | 100 | 100 | 100 |
| | Copolymer B | B1 | 100 | | | | | | | | | | | | | |
| | | B2 | | 100 | | | | | | | | | | | | |
| | | B3 | | | 100 | | | | | | | | | | | |
| | | B4 | | | | 100 | | | | | | | | | | |
| | | B5 | | | | | | | | | | | | | | |
| | Adhesion imparting agent C | C1 | | | | | 30 | 50 | | | | | | | | |
| | | C2 | | | | | | | 30 | 50 | | | | | | |
| | | C3 | | | | | | | | | 30 | 50 | | | | |
| | | C4 | 30 | 30 | 30 | 30 | | | | | | | 30 | 50 | | |
| | | C5 | | | | | | | | | | | | | 30 | 50 |
| Copolymer A content rate % by mass | A/(A + B) | | 0% | 0% | 0% | 0% | 100% | 100% | 100% | 100% | 100% | 100% | 100% | 100% | 100% | 100% |
| | A/total mass | | 0% | 0% | 0% | 0% | 77% | 67% | 77% | 67% | 77% | 67% | 77% | 67% | 77% | 67% |
| Peel strength | 25°C | | 5.91 | 5.55 | 4.82 | 8.09 | 0.09 | 0.09 | 0.45 | 0.73 | 0.09 | 0.09 | 0.27 | 0.18 | 0.18 | 0.09 |
| | 80°C | | 0.73 | 3.91 | 2.82 | 0.00 | 0.36 | 4.00 | 0.64 | 3.82 | 1.00 | 4.73 | 2.00 | 4.55 | 1.55 | 4.73 |
| | 100°C | | 1.36 | 0.55 | 0.18 | 0.00 | 0.73 | 3.64 | 1.00 | 2.82 | 0.82 | 4.64 | 0.36 | 3.64 | 1.55 | 4.55 |
| | 120°C | | 0.64 | 0.09 | 0.09 | 0.00 | 1.73 | 2.91 | 2.09 | 4.55 | 2.64 | 4.64 | 0.64 | 3.00 | 2.64 | 5.18 |

In Examples 1 to 9, in the combination of A1 and B1, when the content rate of the copolymer A based on the copolymers A + B was 10% to 90%, the relative value of the peel strength when the peel strength at 80°C in Comparative Example 9 was set to "1.00" was 1.00 or more at all temperatures of 25°C, 80°C, 100°C, and 120°C.

In Examples 10 to 13, in the combinations of A1 and B2, A1 and B3, A1 and B4, and A1 and B5, the relative value of the peel strength when the peel strength at 80°C in Comparative Example 9 was set to "1.00" was 1.00 or more at all temperatures of 25°C, 80°C, 100°C, and 120°C.

In Examples 14 to 22, in the combination of A1, B1 and B3, the relative value of the peel strength when the peel strength at 80°C in Comparative Example 9 was set to "1.00" was 1.00 or more at all temperatures of 25°C, 80°C, 100°C, and 120°C.

In Examples 23 to 28, in the combinations of A1, B1, and C1 (softening point: 100°C), A1, B1, and C2 (softening point: 115°C), A1, B1, and C3 (softening point: 130°C), and A1, B1, and C5 (softening point: 145°C), the relative value of the peel strength when the peel strength at 80°C in Comparative Example 9 was set to "1.00" was 1.00 or more at all temperatures of 25°C, 80°C, 100°C, and 120°C.

In Comparative Examples 1 to 4, in the combinations of A1 and B1, A1 and B2, A1 and B3, and A1 and B4, when the content rate of the copolymer A based on the copolymers A + B was 0%, the relative value of the peel strength at 120°C when the peel strength at 80°C in Comparative Example 9 was set to "1.00" was below 1.00.

In Comparative Examples 5 to 14, when the content rate of the copolymer A based on the copolymers A + B was 100%, the relative value of the peel strength at 25°C when the peel strength at 80°C in Comparative Example 9 was set to "1.00" was below 1.00.

From the above results, the adhesive layer composed of the adhesive composition of the present invention has high adhesion and excellent close adhesion not only at normal temperatures of about 25°C but also at high temperatures (80°C or higher, for example, 100°C), and thus it is inferred that a sealing material in which the adhesive layer composed of the adhesive composition of the present invention is formed on a sealing base material such as a resin material, a metal material, a paper material, or a cork material has excellent sealability not only at normal temperatures of about 25°C but also at high temperatures (80°C or higher, for example, 100°C).

In addition, from the above results, the adhesive layer composed of the adhesive composition of the present invention has high adhesion and excellent close adhesion not only at normal temperatures of about 25°C but also at high temperatures (80°C or higher, for example, 100°C), and thus it is inferred that a sealing material in which only the adhesive layer composed of the adhesive composition is used as a sealing material without a sealing base material such as a resin material, a metal material, a paper material, or a cork material has excellent sealability not only at normal temperatures of about 25°C but also at high temperatures (80°C or higher, for example, 100°C).

## Claims

1. An adhesive composition comprising:
a copolymer (A) having (a) a polymer block of an α-methylstyrene monomer and (b) a (co)polymerization block of one or more kinds of aliphatic monoolefins and/or one or more kinds of aliphatic conjugated diolefins or a partially or fully hydrogenated block of the (co)polymerization block;
one or more kinds of copolymers (B) having (c) a polymer block of styrene or a monomer having a styrene structure and (d) a (co)polymerization block of one or more kinds of aliphatic monoolefins and/or one or more kinds of aliphatic conjugated diolefins or a partially or fully hydrogenated block of the (co)polymerization block; and
one or more kinds of adhesion imparting agents (C).

2. The adhesive composition according to claim 1, wherein a ratio of a content of the copolymer (A) to a total content of the copolymer (A) and the copolymer (B) ((copolymer (A)/(copolymer (A) + copolymer (B))) × 100) is 5 to 95% by mass.

3. The adhesive composition according to claim 1, wherein a content of an α-methylstyrene unit of the copolymer (A) is 10 to 40% by mass on a monomer basis.

4. The adhesive composition according to claim 1, wherein a content of a styrene unit of the copolymer (B) is 5 to 25% by mass on a monomer basis.

5. The adhesive composition according to claim 1, wherein (b) is a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block.

6. The adhesive composition according to claim 1, wherein (d) is a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block.

7. The adhesive composition according to claim 1, wherein the copolymer (A) is a triblock copolymer composed of (a) a polymer block of an α-methylstyrene monomer-(b) a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block-(a) a polymer block of an α-methylstyrene monomer.

8. The adhesive composition according to claim 1, wherein the copolymer (B) is a triblock copolymer composed of (c) a polymer block of styrene or a monomer having a styrene structure-(d) a copolymer block of one or more kinds of monomers selected from ethylene, propylene, 1-butene, isobutylene, butadiene, isoprene, 6,10-dimethyl-1-undecene, and (6E)-7,11-dimethyl-3-methylidenedodeca-1,6,10-triene or a partially or fully hydrogenated block of the copolymer block-(c) a polymer block of styrene or a monomer having a styrene structure.

9. A sheet-shaped gasket comprising an adhesive layer composed of the adhesive composition according to any one of claims 1 to 8.

10. A flooring material comprising an adhesive layer composed of the adhesive composition according to any one of claims 1 to 8.

11. A sealing material for inside an automotive door comprising an adhesive layer composed of the adhesive composition according to any one of claims 1 to 8.

12. A cushioning material for a fuel tank comprising an adhesive layer composed of the adhesive composition according to any one of claims 1 to 8.

13. A sealing material for an electronic component comprising an adhesive layer composed of the adhesive composition according to any one of claims 1 to 8.

14. A cushioning material for a lithium-ion battery comprising an adhesive layer composed of the adhesive composition according to any one of claims 1 to 8.

15. A sealing material between a solar cell panel and a support member of a module for a solar cell comprising an adhesive layer composed of the adhesive composition according to any one of claims 1 to 8.

16. A sealing material for an electronic device comprising an adhesive layer composed of the adhesive composition according to any one of claims 1 to 8.

17. A sealing material for an electrolytic apparatus comprising an adhesive layer composed of the adhesive composition according to any one of claims 1 to 8.

18. A sealing material for an electrolytic apparatus formed only of an adhesive layer composed of the adhesive composition according to any one of claims 1 to 8.
